# EUROPEAN PATENT APPLICATION

(11) **EP 4 333 583 A1**
(43) Date of publication of application: **06.03.2024**
(21) Application number: 23194321.8
(22) Date of filing: 30.08.2023
(51) Int. Cl.: H05K 7/20

(54) **HEAT DISSIPATION APPARATUS AND DEVICE**

(30) Priority: 30.08.2022 CN 202222291535 U
(71) Applicant: Huawei Digital Power Technologies Co., Ltd., Shenzhen, Guangdong 518043 (CN)
(72) Inventor: WU, Kangqian, Shenzhen, 518043 (CN); MENG, Hao, Shenzhen, 518043 (CN); SUN, Faming, Shenzhen, 518043 (CN); XU, Chunxia, Shenzhen, 518043 (CN)
(74) Representative: Gill Jennings & Every LLP

(57) **Abstract**

Embodiments of this application provide a heat dissipation apparatus and a device. The heat dissipation apparatus includes a housing, a heat dissipation component, a first heat dissipation fan, and a second heat dissipation fan. The housing has a cavity. The cavity includes a first cavity and a second cavity that are not communicated. The first cavity is a sealed cavity. The second cavity communicates with an external environment. The heat dissipation component is disposed in the cavity. The first heat dissipation fan is configured to: transfer heat of a heat emitting element to the heat dissipation component located in the first cavity, and transfer heat of a hot air flow to the heat dissipation component located in the second cavity. The second heat dissipation fan is configured to: suck a cold air flow from the external environment, and perform heat exchange with the heat dissipation component in the second cavity. Therefore, a heat dissipation area inside the first cavity can be enlarged under a joint action of the heat dissipation component, the first heat dissipation fan, and the second heat dissipation fan. In addition, the hot air flow passes through the heat dissipation component at a high speed, so that a convective heat exchange capability can be improved. This enhances a heat dissipation capability of the first cavity to a maximum extent, and further helps reduce heat dissipation costs.

## Description

### TECHNICAL FIELD

Embodiments of this application relate to the field of heat dissipation technologies, and in particular, to a heat dissipation apparatus and a device.

### BACKGROUND

A device is an important apparatus in a photovoltaic power generation system and other power systems, and is a converter that converts a direct current (in a storage battery, a switch-mode power supply, a fuel cell, or the like) into a constant-frequency and constant-voltage or variable-frequency and variable-voltage alternating current (usually a 220 V and 50 Hz sine wave). The output alternating current may be used for various devices to meet a requirement of a mobile power supply site or a region with no electricity for alternating current power to a maximum extent.

The device includes a box and an electronic element (also referred to as a heat emitting element) encapsulated in the box. The box functions to secure and protect the electronic element. When the device runs, the electronic element inevitably generates a specific amount of heat. If the heat is not dissipated in time, normal operation of the device is affected. In a related technology, the heat of the electronic element is usually dissipated in a plurality of manners. For example, heat is dissipated through a wall surface of the box. Alternatively, a heat dissipation fan, a heat exchanger, or the like is disposed inside the box to dissipate the heat of the electronic element.

However, a disposing manner in the related technology has poor effects of dissipating the heat of the electronic element, and requires high heat dissipation costs.

### SUMMARY

Embodiments of this application provide a heat dissipation apparatus and a device. A heat dissipation area inside a first cavity can be enlarged under a joint action of a heat dissipation component, a first heat dissipation fan, and a second heat dissipation fan. In addition, a hot air flow passes through the heat dissipation component at a high speed, so that a convective heat exchange capability can be improved. This enhances a heat dissipation capability of the first cavity to a maximum extent, and further helps reduce heat dissipation costs.

According to a first aspect, an embodiment of this application provides a heat dissipation apparatus, configured to dissipate heat of a heat emitting element in a device and including a housing, a heat dissipation component, a first heat dissipation fan, and a second heat dissipation fan. The housing has a cavity. The cavity includes a first cavity and a second cavity that are not communicated. The first cavity is a sealed cavity. The second cavity communicates with an external environment. The first cavity is configured to accommodate the heat emitting element. The heat dissipation component is disposed in the cavity. One part of the heat dissipation component is located in the first cavity. The other part of the heat dissipation component is located in the second cavity. The heat dissipation component located in the first cavity is in thermal conduction with the heat dissipation component located in the second cavity. The heat dissipation component located in the first cavity is configured to dissipate the heat of the heat emitting element. The first heat dissipation fan is disposed in the first cavity, and is configured to: transfer the heat of the heat emitting element to the heat dissipation component located in the first cavity, and transfer heat of a hot air flow to the heat dissipation component located in the second cavity. The second heat dissipation fan is disposed in the second cavity, and is configured to: suck a cold air flow from the external environment, perform heat exchange with the heat dissipation component located in the second cavity, and exhaust a hot air flow generated through the heat exchange to the external environment.

The heat dissipation apparatus provided in this embodiment of this application includes the first cavity and the second cavity. The first cavity is a sealed cavity. The first cavity is not communicated with the external environment. In this way, air flow heat exchange inside the sealed cavity can be implemented. In addition, the sealed cavity can protect the heat emitting element inside the first cavity, and prevent dust, water stains, polluted cold air, and the like in the external environment from entering the first cavity through the second cavity, thereby avoiding damage to the heat emitting element and protecting the heat emitting element inside the first cavity to a maximum extent. This helps improve an overall protection level of the device and prolong a service life of the device. The second cavity is included, and the second cavity is communicated with the external environment, so that a cold air duct is formed inside the second cavity. Cold air in the external environment enters the second cavity, thereby implementing heat exchange with the hot air flow in the second cavity.

The heat dissipation component is included. In this way, the heat dissipation component dissipates the heat of the heat emitting element to reduce a temperature of the heat emitting element, thereby ensuring that the temperature of the heat emitting element remains within a preset range. The first heat dissipation fan is included, and the first heat dissipation fan is disposed in the first cavity. The first heat dissipation fan can promote flow of air inside the first cavity, and an internal circulating air duct is formed in the first cavity. The hot air flow passes through the heat dissipation component at a high speed, and a convective heat exchange coefficient is increased to a maximum extent, thereby transferring the heat of the heat emitting element to the heat dissipation component located in the first cavity and transferring the heat to the heat dissipation component located in the second cavity. The second heat dissipation fan is included, and the second heat dissipation fan is disposed in the second cavity. The second heat dissipation fan can promote flow of air inside the second cavity, and a forced cold air duct is formed in the second cavity, thereby increasing a heat exchange speed with the hot air flow in the second cavity, and improving overall heat dissipation efficiency of the device. The heat dissipation component and the heat dissipation fans are combined for use. Therefore, compared with a manner in which a heat exchanger is disposed in a related technology, this application can further resolve, at low costs, a problem that the heat emitting element is overheated due to an increase in heat consumption density inside the first cavity. In addition, there is no risk of air leakage in this application.

In a possible implementation, the heat dissipation component includes a heat dissipation substrate and a heat dissipation fin. The heat dissipation substrate includes, along a thickness direction of the heat dissipation substrate, a first surface and a second surface. The first surface is a surface, facing the first cavity, of the heat dissipation substrate. The second surface is a surface, facing the second cavity, of the heat dissipation substrate. The heat dissipation fin is disposed on the heat dissipation substrate, and is in thermal conduction with the heat dissipation substrate.

The heat dissipation substrate is included. The heat dissipation substrate can take away the heat of the heat emitting element, thereby ensuring a heat dissipation capability of the device. The heat dissipation fin is included. When the hot air flow passes through the heat dissipation fin at a high speed, a convective heat exchange coefficient between the hot air flow and the heat dissipation fin can be increased to a maximum extent. The heat dissipation fin is disposed to be in thermal conduction with the heat dissipation substrate. In this way, the heat generated by the heat emitting element can be transferred, through one part of the heat dissipation component in the first cavity, to the other part of the heat dissipation component in the second cavity, and the heat is further dissipated through direct ventilation in the external environment.

In a possible implementation, the heat dissipation substrate includes a first heat dissipation substrate. The heat dissipation fin includes a first heat dissipation fin and a second heat dissipation fin. The first heat dissipation substrate is disposed in the first cavity or the second cavity. The first heat dissipation fin is disposed in the first cavity and located on a side on which a first surface of the first heat dissipation substrate is located. The second heat dissipation fin is disposed in the second cavity and located on a side on which a second surface of the first heat dissipation substrate is located.

In a possible implementation, the heat dissipation substrate includes a first heat dissipation substrate and a second heat dissipation substrate. The heat dissipation fin includes a first heat dissipation fin and a second heat dissipation fin. The first heat dissipation substrate and the first heat dissipation fin are disposed in the first cavity. The first heat dissipation fin is located on a first surface of the first heat dissipation substrate. The second heat dissipation substrate and the second heat dissipation fin are disposed in the second cavity. The second heat dissipation fin is located on a second surface of the second heat dissipation substrate.

Positions of the heat dissipation substrate and the heat dissipation fin are arranged, so that the heat dissipation component may be arranged in more diversified manners. This improves flexibility of disposing the heat dissipation substrate and the heat dissipation fin, and can take away the heat of the heat emitting element from different directions, to adapt to different application scenarios.

In a possible implementation, the heat dissipation apparatus further includes an air hood. The air hood is disposed in the first cavity. An air duct is formed in the air hood. The air duct has a first air vent and a second air vent that communicate with each other. The second air vent faces the first heat dissipation fan.

The air hood is included. The air hood has the air duct. On the one hand, a flow direction of air can be guided, thereby improving heat dissipation efficiency. On the other hand, the air flow can be more concentrated, thereby increasing the heat exchange speed to a maximum extent and improving the overall heat dissipation efficiency of the device.

In a possible implementation, the first heat dissipation fan is an air suction fan, the first air vent is an air inlet, and the second air vent is an air outlet. Alternatively, the first heat dissipation fan is an air exhaust fan, the first air vent is an air outlet, and the second air vent is an air inlet.

In a possible implementation, a cold air flow inlet and a hot air flow outlet are disposed on the housing. Both the cold air flow inlet and the hot air flow outlet communicate with the second cavity. The second heat dissipation fan is configured to: suck the cold air flow from the external environment through the cold air flow inlet, perform heat exchange with the heat dissipation component located in the second cavity, and exhaust, through the hot air flow outlet, the hot air flow generated through heat exchange to the external environment. The second cavity, the cold air flow inlet, the external environment, and the hot air flow outlet form a circulating cold and hot air flow exchange loop.

The cold air flow inlet and the hot air flow outlet are included. Under the action of the second heat dissipation fan, the cold air flow inlet is configured to suck the cold air flow from the external environment, and the hot air flow outlet is configured to exhaust the hot air flow. In this way, the circulating cold and hot air flow exchange loop is formed. Therefore, the heat of the heat emitting element can be dissipated continuously, and heat dissipation effects are ensured to a maximum extent.

In a possible implementation, the heat dissipation apparatus further includes a separator. The separator is disposed in the cavity, and divides the cavity into the first cavity and the second cavity. An opening is provided on the separator at a position close to the first heat dissipation substrate and the second heat dissipation substrate. The opening communicates with the first cavity and the second cavity. A projection of at least one of the first heat dissipation substrate and the second heat dissipation substrate on the separator covers the opening. The first heat dissipation substrate and the second heat dissipation substrate are in contact with each other through the opening, and implement thermal conduction.

The separator is included, so that the first cavity and the second cavity can be separated. Therefore, sealing of the first cavity is ensured, and the heat emitting element inside the first cavity is protected to a maximum extent. This helps improve the overall protection level of the device and prolong the service life of the device. The opening is provided on the separator at the position close to the first heat dissipation substrate and the second heat dissipation substrate, so that thermal conduction between the first heat dissipation substrate and the second heat dissipation substrate can be implemented.

In a possible implementation, the heat dissipation apparatus further includes a thermally conductive medium. The thermally conductive medium is disposed at the opening and located between the first heat dissipation substrate and the second heat dissipation substrate. The first heat dissipation substrate and the second heat dissipation substrate implement thermal conduction by using the thermally conductive medium.

The thermally conductive medium is included. Thermal conductivity of the thermally conductive medium is better than that of air. On the one hand, a gap between the first heat dissipation substrate and the second heat dissipation substrate can be filled, and air in the gap is extruded out of a contact surface, so that the heat can be smoothly conducted out by using the thermally conductive medium. In this way, heat transfer between the first heat dissipation substrate and the second heat dissipation substrate is implemented, and the heat dissipation effects are ensured to a maximum extent. On the other hand, the thermally conductive medium has specific natural viscosity, so that connection performance is good, and both operability and maintainability are high.

In a possible implementation, an assembly slot is provided on a surface of the first heat dissipation substrate. The assembly slot is opened toward the first cavity. At least a part of the heat emitting element is accommodated in the assembly slot.

There are a plurality of heat emitting elements. There are a plurality of assembly slots. The plurality of heat emitting elements are accommodated in the assembly slots in a one-to-one correspondence manner.

In a possible implementation, the first heat dissipation fin is disposed on a part of the surface of the first heat dissipation substrate excluding the assembly slot.

In this way, on the one hand, the first heat dissipation fin located in the first cavity may be arranged in more diversified manners. On the other hand, in this disposing manner, a heat dissipation area of the first heat dissipation fin is larger, so that a heat dissipation area inside the first cavity can be enlarged to a maximum extent, and a heat dissipation capability of the first cavity is further improved.

In a possible implementation, the heat dissipation component, the first heat dissipation fan, and the air hood that are located in the first cavity are integrated.

The heat dissipation component, the first heat dissipation fan, and the air hood that are located in the first cavity are disposed to be integrated. On the one hand, assembly components and assembly steps between components such as the heat dissipation component and the first heat dissipation fan can be simplified, thereby helping ensure that a position relationship between the foregoing structures is constant. On the other hand, when heat dissipation needs to be performed on another device, the entire apparatus may be moved more conveniently. In addition, flexible design adjustment and installation may be implemented based on a spatial position and the like inside the first cavity.

According to a second aspect, an embodiment of this application provides a device, including a box, a heat emitting element, and the foregoing heat dissipation apparatus. The box has an accommodating cavity. The heat dissipation apparatus is accommodated in the accommodating cavity. The heat emitting element is accommodated in the first cavity of the heat dissipation apparatus.

The device provided in this embodiment of this application is provided with the foregoing heat dissipation apparatus. The heat dissipation apparatus includes the heat dissipation component, the first heat dissipation fan, and the second heat dissipation fan. The heat dissipation area inside the first cavity can be enlarged under a joint action of the heat dissipation component and the heat dissipation fans. In addition, the hot air flow passes through the heat dissipation component at a high speed, so that a convective heat exchange capability can be improved, which enhances the heat dissipation capability of the first cavity to a maximum extent, and further helps reduce heat dissipation costs.

These and other aspects, implementations, and advantages of example embodiments will become evident with reference to the accompanying drawings and based on embodiments described below. However, it should be understood that the specification and the accompanying drawings are only intended for illustrative purposes and do not serve as definitions that limit this application. Details are described in the appended claims. Other aspects and advantages of this application will be described in the following descriptions. Some aspects and advantages will become evident in the descriptions or learned of through practice of this application. In addition, the aspects and the advantages of this application may be achieved and obtained by using methods particularly specified in the appended claims or a combination thereof.

### BRIEF DESCRIPTION OF DRAWINGS

FIG. 1 is a schematic diagram of a structure of a heat dissipation apparatus of a first structure in a related technology according to this application;
FIG. 2 is a schematic diagram of a structure of a heat dissipation apparatus of a second structure in a related technology according to this application;
FIG. 3 is a schematic diagram of a structure of a heat dissipation apparatus according to this application;
FIG. 4 is a schematic diagram of flow directions of a hot air flow and a cold air flow of a heat dissipation apparatus according to this application;
FIG. 5 is a schematic diagram 1 of a structure of a heat dissipation component of a heat dissipation apparatus according to this application;
FIG. 6 is a schematic diagram 2 of a structure of a heat dissipation component of a heat dissipation apparatus according to this application;
FIG. 7 is a front view of an integrated heat dissipation component of a heat dissipation apparatus according to this application;
FIG. 8 is a side view of an integrated heat dissipation component of a heat dissipation apparatus according to this application;
FIG. 9 is a schematic diagram of an assembly structure of a heat dissipation component of a heat dissipation apparatus and a heat emitting element according to this application;
FIG. 10 is a schematic diagram 1 of a structure of a heat dissipation apparatus including a heat emitting element according to this application; and
FIG. 11 is a schematic diagram 2 of a structure of a heat dissipation apparatus including a heat emitting element according to this application.

### Description of reference signs:

100-heat dissipation apparatus; 110-housing; 111-cavity;
1111-first cavity; 1112-second cavity; 11121-cold air flow inlet;
11122-hot air flow outlet; 120-heat dissipation component; 121-heat dissipation substrate;
1211-first surface; 1212-second surface; 1213-first heat dissipation substrate;
1214-second heat dissipation substrate; 1215-assembly slot; 122-heat dissipation fin;
1221-first heat dissipation fin; 1222-second heat dissipation fin; 130-first heat dissipation fan;
140-second heat dissipation fan; 150-air hood; 151-air duct;
160-separator; 200-device; 210-box;
211-accommodating cavity; 220-heat emitting element; 230-circuit board.

### DESCRIPTION OF EMBODIMENTS

Some terms used in embodiments of this application are only used to explain specific embodiments of this application, but are not intended to limit this application.

An inverter is an interface device between a solar power generation system and a power grid. Heat dissipation performance of the inverter has great impact on operational stability of an entire device system, a service life of a power device, and a size of a product. A plurality of components are disposed inside the device, for example, a power component of a high protection level such as a reactor, a resistor, and a heat sink, and a power component of a low protection level such as an inverter module, a capacitor component, a direct current circuit breaker component, an alternating current capacitor, an alternating current circuit breaker, and an alternating current contactor.

The device includes a box, an electronic element, a circuit board, a heat sink, and the like. A heat emitting element, the circuit board, the heat sink, and the like are all encapsulated inside the box. The box is configured to secure and protect the electronic element. The heat sink is a sealed cold plate capable of accommodating a cooling medium flow, and is usually attached to the heat emitting element by using a thermally conductive interface material, to take away heat of the heat emitting element.

When the device runs, the electronic element inevitably generates a specific amount of heat. If the heat is not dissipated in time, normal operation of the device is affected. Heat of most devices is dissipated through only a wall surface of the box. However, as device power increases continuously, heat consumption density of the electronic element in the device increases continuously. If the heat is dissipated through only the wall surface of the box, without enhancing a heat dissipation technology, a temperature of the electronic element will exceed an allowable temperature, which affects the normal operation of the device. Therefore, in a related technology, the heat of the electronic element is often dissipated in a plurality of manners.

The following describes technical solutions related to this application.

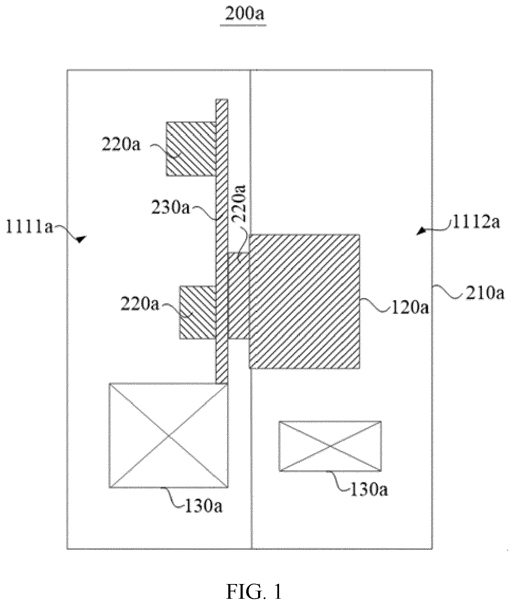

In a related technology, as shown in FIG. 1, a device 200a includes a first cavity 1111a and a second cavity 1112a. The first cavity 1111a is a high-protection sealed cavity. The second cavity 1112a is a low-protection sealed cavity. A heat emitting element 220a, a circuit board 230a, and the like are accommodated in the first cavity 1111a. To effectively dissipate heat of the heat emitting element 220a, both the first cavity 1111a and the second cavity 1112a are usually disposed with a heat dissipation fan 130a in , and a heat sink 120a is disposed in the second cavity 1112a. The heat dissipation fan 130a and an inner wall surface of a box 210a jointly dissipate the heat of the heat emitting element 220a.

However, in the related technology, heat dissipation is implemented by using only the heat dissipation fan 130a and the inner wall surface of the box 210a. As power of the device 200a increases continuously, heat consumption density of the heat emitting element 220a in the device 200a increases continuously. In the foregoing manner, a heat dissipation requirement cannot be well satisfied. As a result, a temperature of the heat emitting element 220a is higher than an allowable temperature, affecting normal operation of the device 200a.

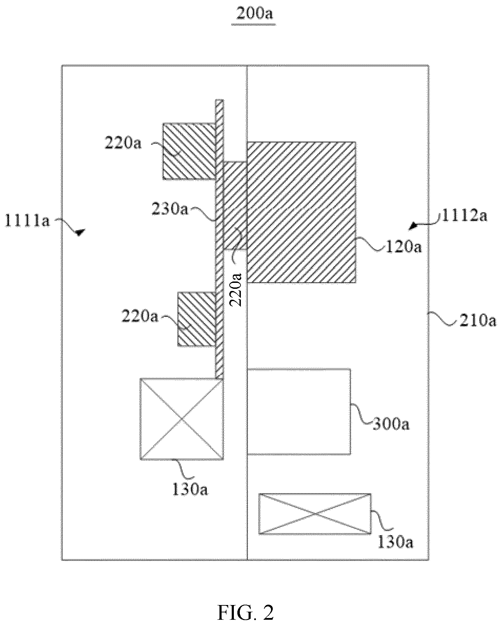

In another related technology, as shown in FIG. 2, this technical solution is based on the first related technical solution. A heat exchanger 300a is further disposed in the second cavity 1112a. A hot air flow in the first cavity 1111a enters the heat exchanger 300a through an air inlet of the heat exchanger 300a. The hot air flow is dissipated by using the heat exchanger 300a. A cold air flow is circulated back to the first cavity 1111a through an air outlet of the heat exchanger 300a.

However, in the related technology, to implement air flow circulation, two through holes are usually provided on a baffle plate 160a between the first cavity 1111a and the second cavity 1112a. The hot air flow in the first cavity 1111a enters the heat exchanger 300a through one of the through holes, and the cold air flow after heat exchange is circulated back to the first cavity 1111a through the other through hole. However, in the foregoing manner, on the one hand, the heat exchanger 300a is prone to air leakage in a machining process On the other hand, the heat exchanger 300a needs to be added, so that heat exchange costs are high.

Based on this, embodiments of this application provide a heat dissipation apparatus 100 and a device 200. A first cavity 1111 and the second cavity 1112 are included. The first cavity 1111 is a sealed cavity. The first cavity 1111 is not communicated with an external environment. In this way, air flow heat exchange inside the sealed cavity can be implemented. In addition, the sealed cavity can protect a heat emitting element 220 inside the first cavity 1111, and prevent dust, water stains, polluted cold air, and the like in the external environment from entering the first cavity 1111 through the second cavity 1112, thereby avoiding damage to the heat emitting element 220 and protecting the heat emitting element 220 inside the first cavity 1111 to a maximum extent. This helps improve an overall protection level of the device 200 and prolong a service life of the device 200. The second cavity 1112 is included, and the second cavity 1112 is communicated with the external environment, so that a cold air duct is formed inside the second cavity 1112. Cold air in the external environment enters the second cavity 1112, thereby implementing heat exchange with the hot air flow in the second cavity 1112.

A heat dissipation component 120 is included. In this way, the heat dissipation component 120 dissipates heat of the heat emitting element 220 to reduce a temperature of the heat emitting element 220, thereby ensuring that the temperature of the heat emitting element 220 remains within a preset range. A first heat dissipation fan 130 is included, and the first heat dissipation fan 130 is disposed in the first cavity 1111. The first heat dissipation fan 130 can promote flow of air inside the first cavity 1111, and an internal circulating air duct is formed in the first cavity 1111. The hot air flow passes through the heat dissipation component 120 at a high speed, and a convective heat exchange capability is improved to a maximum extent, thereby transferring the heat of the heat emitting element 220 to the heat dissipation component 120 located in the first cavity 1111 and transferring the heat to the heat dissipation component 120 located in the second cavity 1112. A second heat dissipation fan 140 is included, and the second heat dissipation fan 140 is disposed in the second cavity 1112. The second heat dissipation fan 140 can promote flow of air inside the second cavity 1112, and a forced cold air duct is formed in the second cavity 1112, thereby increasing a heat exchange speed with the hot air flow in the second cavity 1112 and improving overall heat dissipation efficiency of the device 200. The heat dissipation component 120, the first heat dissipation fan 130, and the second heat dissipation fan 140 are combined for use. Therefore, compared with a manner in the related technology in which a heat exchanger is disposed, this application can further resolve, at lower costs, a problem that the heat emitting element 220 is overheated due to an increase in heat consumption density inside the first cavity 1111. In addition, there is no risk of air leakage in this application.

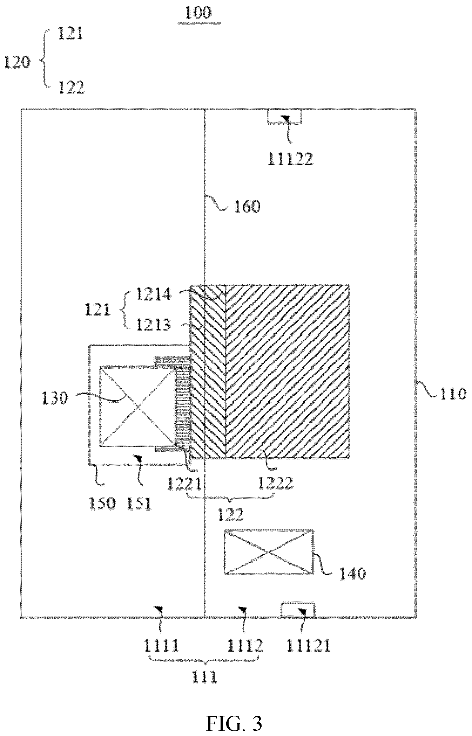

The following describes a specific structure of the heat dissipation apparatus 100 in detail with reference to FIG. 3 to FIG. 9.

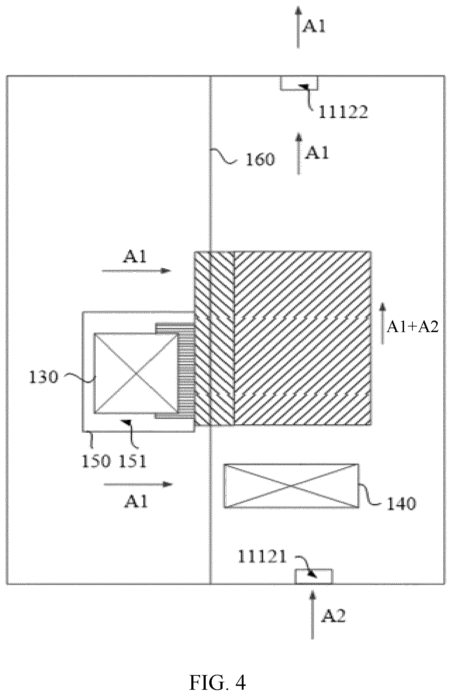

Referring to FIG. 3 and FIG. 4, an embodiment of this application provides a heat dissipation apparatus 100. The heat dissipation apparatus 100 may include a housing 110, a heat dissipation component 120, a first heat dissipation fan 130, and a second heat dissipation fan 140. The heat dissipation apparatus 100 is configured to dissipate heat of a heat emitting element 220 in a device 200. The device 200 in this embodiment of this application may be an inverter.

The heat emitting element 220 is a general name of various heat emitting parts and components. The heat emitting element 220 may be a component such as a circuit board, a resistor, a central processing unit, a graphics processing unit, a heat sink, a capacitor, a power supply, or a memory. In addition, there may be one or more heat emitting elements 220, and this is not limited herein.

Referring to FIG. 3, the housing 110 has a cavity 111. The cavity 111 can protect the heat dissipation component 120, the first heat dissipation fan 130, and the second heat dissipation fan 140, thereby avoiding a problem that the heat dissipation component 120, the first heat dissipation fan 130, and the second heat dissipation fan 140 are contaminated by external impurities, and ensuring heat dissipation effects of the heat dissipation component 120 and the like. In addition, a shape of the housing 110 is not limited. The shape of the housing 110 includes but is not limited to structures such as a square, a round, an ellipse, and a diamond.

Still referring to FIG. 3, the cavity 111 includes a first cavity 1111 and a second cavity 1112 that are not communicated. The first cavity 1111 is a sealed cavity. The first cavity 1111 is configured to accommodate the heat emitting element 220. The sealed cavity has good sealing performance. On the one hand, it is ensured that the first cavity 1111 is not communicated with an external environment, so that air flow heat exchange inside the sealed cavity is implemented. On the other hand, the sealed cavity can protect the heat emitting element 220 inside the first cavity 1111, and prevent dust, water stains, polluted cold air, and the like in the external environment from entering the first cavity 1111 through the second cavity 1112, thereby avoiding damage to the heat emitting element 220 and protecting the heat emitting element 220 inside the first cavity 1111 to a maximum extent. This helps improve an overall protection level of the device 200 and prolong a service life of the device 200.

The second cavity 1112 is communicated with the external environment, so that a cold air duct is formed inside the second cavity 1112. Therefore, cold air in the external environment enters the second cavity 1112, and implements heat exchange with a hot air flow in the second cavity 1112.

The heat dissipation component 120 is disposed in the cavity 111. One part of the heat dissipation component 120 is located in the first cavity 1111. The other part of the heat dissipation component 120 is located in the second cavity 1112. The heat dissipation component 120 located in the first cavity 1111 is in thermal conduction with the heat dissipation component 120 located in the second cavity 1112. The heat dissipation component 120 is configured to dissipate the heat of the heat emitting element 220.

It should be noted that thermal conduction means that a thermally conductive layer may be disposed between the heat dissipation component 120 located in the first cavity 1111 and the heat dissipation component 120 located in the second cavity 1112, or another thermally conductive material may be disposed, to facilitate heat transfer between the heat dissipation component 120 located in the first cavity 1111 and the heat dissipation component 120 located in the second cavity 1112.

The heat dissipation component 120 is included. The heat dissipation component 120 dissipates the heat of the heat emitting element 220 to reduce a temperature of the heat emitting element 220, thereby ensuring that the temperature of the heat emitting element 220 remains within a preset range.

Still referring to FIG. 3, to further improve heat dissipation efficiency, in this embodiment of this application, the heat dissipation apparatus 100 further includes the first heat dissipation fan 130 and the second heat dissipation fan 140. The first heat dissipation fan 130 is disposed in the first cavity 1111. The first heat dissipation fan 130 can promote flow of air inside the first cavity 1111, so that an internal circulating air duct is formed in the first cavity 1111. The hot air flow passes through the heat dissipation component 120 at a high speed, and a convective heat exchange capability is increased to a maximum extent, thereby transferring the heat of the heat emitting element 220 to the heat dissipation component 120 located in the first cavity 1111 and transferring the heat to the heat dissipation component 120 located in the second cavity 1112.

The second heat dissipation fan 140 is disposed in the second cavity 1112. The second heat dissipation fan 140 can promote flow of air inside the second cavity 1112, and a forced cold air duct is formed in the second cavity 1112, thereby increasing a heat exchange speed with the hot air flow in the second cavity 1112, and improving overall heat dissipation efficiency of the device 200.

It should be noted that, referring to FIG. 4, for a flow direction of the hot airflow in this embodiment of this application, refer to a direction of an arrow A1 in FIG. 4, and for a flow direction of the cold airflow, refer to a direction of an arrow A2 in FIG. 4.

The heat dissipation component 120, the first heat dissipation fan 130, and the second heat dissipation fan 140 are combined for use. Therefore, compared with the related technology, on the one hand, the heat exchange speed with the hot air flow in the second cavity 1112 may be increased, and the overall heat dissipation efficiency of the device 200 may be improved. On the other hand, compared with a manner in which a heat exchanger is disposed, this application can further resolve, at low costs, a problem that the heat emitting element 220 is overheated due to an increase in heat consumption density inside the first cavity 1111. In addition, there is no risk of air leakage.

In addition, it may be added that, in this embodiment of this application, neither a connection relationship nor a position relationship between the heat dissipation component 120 and the heat emitting element 220 is further limited.

For example, in a first possible implementation, the heat dissipation component 120 is disposed on the heat emitting element 220, and the heat dissipation component 120 partially presses against the heat emitting element 220. In a second possible implementation, the heat dissipation component 120 is disposed on the heat emitting element 220, and the heat dissipation component 120 entirely presses against the heat emitting element 220. In a third possible implementation, the heat dissipation component 120 does not press against the heat emitting element 220. For example, the heat dissipation component 120 may be attached to a surface of the heat emitting element 220 by using a thermally conductive interface material, and may be in contact with the heat emitting element 220 for heat transfer. In a fourth possible implementation, an assembly slot 1215 may be provided on a surface of a side, close to the heat emitting element 220, of the heat dissipation component 120, and the heat emitting element 220 is accommodated in the assembly slot 1215. The assembly slot 1215 is included, and the heat emitting element 220 may be accommodated in the assembly slot 1215, so that the heat emitting element 220 is arranged more compactly, designed more flexibly, and installed easily, and flexible design adjustment and installation may be implemented based on an arrangement and a spatial position of the heat emitting element 220 in the cavity 111.

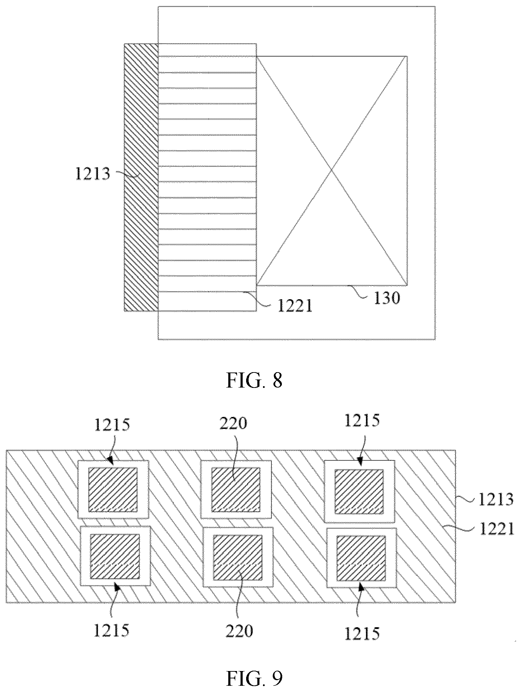

A quantity of assembly slots 1215 and a quantity of heat emitting elements 220 are not further limited. For example, there may be a plurality of heat emitting elements 220, there may be a plurality of assembly slots 1215, and the plurality of heat emitting elements 220 are accommodated in the assembly slots 1215 in a one-to-one correspondence manner (for details, refer to FIG. 9).

It should be noted that, in this embodiment of this application, the connection relationship between the heat dissipation component 120 and the heat emitting element 220 includes but is not limited to the foregoing four implementations. A connection relationship under which a heat dissipation function of the heat dissipation component 120 for the heat emitting element 220 may be implemented falls within the protection scope of this application.

In a possible implementation, referring to FIG. 3, the heat dissipation component 120 may include a heat dissipation substrate 121 and a heat dissipation fin 122. One part of the heat dissipation substrate 121 and one part of the heat dissipation fin 122 are located in the first cavity 1111. The other part of the heat dissipation substrate 121 and the other part of the heat dissipation fin 122 are located in the second cavity 1112.

The foregoing implementation may be explained as follows: For example, the heat dissipation substrate 121 is located in the first cavity 1111, and the heat dissipation fin 122 is located in the second cavity 1112. Alternatively, the heat dissipation substrate 121 is located in the second cavity 1112, and the heat dissipation fin 122 is located in the first cavity 1111. This may be set based on an actual requirement. This is not limited in this embodiment of this application.

The heat dissipation substrate 121 includes, along a thickness direction of the heat dissipation substrate 121, a first surface 1211 and a second surface 1212. The first surface 1211 is a surface, facing the first cavity 1111, of the heat dissipation substrate 121. The second surface 1212 is a surface, facing the second cavity 1112, of the heat dissipation substrate 121. The heat dissipation fin 122 is disposed on the heat dissipation substrate 121, and is in thermal conduction with the heat dissipation substrate 121.

The heat dissipation substrate 121 is included. The heat dissipation substrate 121 can take away the heat of the heat emitting element 220, thereby ensuring a heat dissipation capability of the device 200. The heat dissipation fin 122 is included. When the hot air flow passes through the heat dissipation fin 122 at a high speed, the convective heat exchange capability between the hot air flow and the heat dissipation fin 122 can be improved to a maximum extent. The heat dissipation fin 122 is disposed to be in thermal conduction with the heat dissipation substrate 121. In this way, the heat generated by the heat emitting element 220 can be transferred, through one part of the heat dissipation component 120 in the first cavity 1111, to the other part of the heat dissipation component 120 in the second cavity 1112, and the heat is further dissipated through direct ventilation in the external environment.

In this embodiment of this application, an arrangement manner of the heat dissipation substrate 121 and the heat dissipation fin 122 is described by using the following two manners as examples.

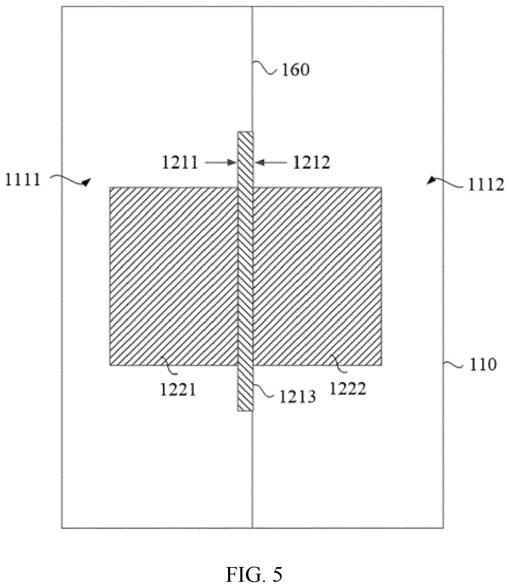

In a first possible implementation, referring to FIG. 5, the heat dissipation substrate 121 includes a first heat dissipation substrate 1213. The heat dissipation fin 122 includes a first heat dissipation fin 1221 and a second heat dissipation fin 1222. The first heat dissipation substrate 1213 is disposed in the first cavity 1111. The first heat dissipation fin 1221 is disposed in the first cavity 1111 and located on a side on which a first surface 1211 of the first heat dissipation substrate 1213 is located. The second heat dissipation fin 1222 is disposed in the second cavity 1112 and located on a side on which a second surface 1212 of the first heat dissipation substrate 1213 is located. The first heat dissipation fin 1221 and the second heat dissipation fin 1222 are separately in thermal conduction with the first heat dissipation substrate 1213. Alternatively, the first heat dissipation fin 1221 and the second heat dissipation fin 1222 may be disposed reversely.

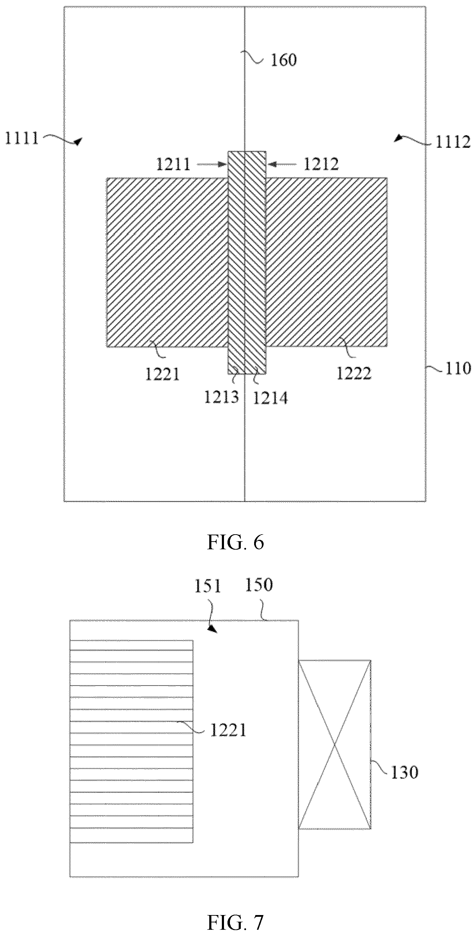

In a second possible implementation, referring to FIG. 6, the heat dissipation substrate 121 includes a first heat dissipation substrate 1213 and a second heat dissipation substrate 1214. The heat dissipation fin 122 includes a first heat dissipation fin 1221 and a second heat dissipation fin 1222. The first heat dissipation substrate 1213 is disposed in the first cavity 1111. The second heat dissipation substrate 1214 is disposed in the second cavity 1112. The first heat dissipation fin 1221 is disposed in the first cavity 1111 and located on a first surface 1211. The second heat dissipation fin 1222 is disposed in the second cavity 1112 and located on a second surface 1212. Alternatively, the first heat dissipation fin 1221 and the second heat dissipation fin 1222 may be disposed reversely.

It should be noted that, in this embodiment, the arrangement manner of the heat dissipation substrate 121 and the heat dissipation fin 122 includes but is not limited to the foregoing two implementations. An arrangement manner in which it may be ensured that the heat dissipation fin 122 is disposed in both the first cavity 1111 and the second cavity 1112 and a heat dissipation area inside the first cavity 1111 can be increased falls within the protection scope of this application.

Positions of the heat dissipation substrate 121 and the heat dissipation fin 122 are arranged, so that the heat dissipation component 120 may be arranged in more diversified manners. This improves flexibility of disposing the heat dissipation substrate 121 and the heat dissipation fin 122, and can take away the heat of the heat emitting element 220 from different directions, to adapt to different application scenarios.

In a possible implementation, referring to FIG. 3, the heat dissipation apparatus 100 may further include an air hood 150. The air hood 150 is disposed in the first cavity 1111. An air duct 151 is formed in the air hood 150. The air duct 151 has a first air vent and a second air vent that communicate with each other. The second air vent faces the first heat dissipation fan 130.

The air hood 150 is included. The air hood 150 has the air duct 151. On the one hand, a flow direction of air can be guided, thereby improving heat dissipation efficiency. On the other hand, the air flow can be more concentrated, thereby increasing the heat exchange speed to a maximum extent and improving the overall heat dissipation efficiency of the device 200.

It should be noted that, in this embodiment of this application, the second cavity 1112 may also be used as an air duct.

In specific application, in a possible implementation, the first heat dissipation fan 130 may be an air suction fan, the first air vent is an air inlet, and the second air vent is an air outlet. The first heat dissipation fan 130 is disposed as the air suction fan, so that the hot air flow on the heat emitting element 220 in the first cavity 1111 can be sucked through the first air vent and exhausted from the second air vent to the external environment through the air duct 151.

In another possible implementation, the first heat dissipation fan 130 may be an air exhaust fan, the first air vent is an air outlet, and the second air vent is an air inlet. The first heat dissipation fan 130 is disposed as the air exhaust fan, so that the cold air flow can be sucked from the external environment through the second air vent and blown into the first cavity 1111 from the first air vent through the air duct 151, to take away the hot air flow on the heat emitting element 220 in the first cavity 1111.

It should be noted that the first air vent is located in the first cavity 1111. A specific direction of the first air vent is not further limited. For example, the first air vent may face the heat emitting element 220, or may face another direction in the first cavity 1111. A direction under which the hot air flow on the heat emitting element 220 can be taken away falls within the protection scope of this application.

In a possible implementation, referring to FIG. 3, a cold air flow inlet 11121 and a hot air flow outlet 11122 may be disposed on the housing 110. Both the cold air flow inlet 11121 and the hot air flow outlet 11122 communicate with the second cavity 1112. In this way, during heat dissipation, under the action of the second heat dissipation fan 140, the cold air flow inlet 11121 is configured to suck the cold air flow from the external environment. After heat exchange is performed between the cold air flow and the hot air flow in the second cavity 1112, the hot air flow is exhausted to the external environment through the second cavity 1112 and the hot air flow outlet 11122. In this way, the second cavity 1112, the cold air flow inlet 11121, the external environment, and the hot air flow outlet 11122 form a circulating cold and hot air flow exchange loop. Therefore, the heat of the heat emitting element 220 can be dissipated continuously, and heat dissipation effects are ensured to a maximum extent.

In consideration of a principle that an air flow rises, in this embodiment of this application, the hot air flow outlet 11122 is located above the cold air flow inlet 11121. For example, the cold air flow inlet 11121 may be disposed on a bottom wall of the housing 110, and the hot air flow outlet 11122 may be disposed on a side wall or a top wall of the housing 110. Alternatively, both the cold air flow inlet 11121 and the hot air flow outlet 11122 may be disposed on a side wall of the housing 110. This is not limited in this embodiment of this application. A disposing manner in which the circulating cold and hot air flow exchange loop may be formed falls within the protection scope of this application.

In a possible implementation, referring to FIG. 3, the heat dissipation apparatus 100 may further include a separator 160. The separator 160 is disposed in the cavity 111, and divides the cavity 111 into the first cavity 1111 and the second cavity 1112.

In specific application, an opening is provided on the separator 160 at a position close to the first heat dissipation substrate 1213 and the second heat dissipation substrate 1214. The opening communicates with the first cavity 1111 and the second cavity 1112. A projection of at least one of the first heat dissipation substrate 1213 and the second heat dissipation substrate 1214 on the separator 160 covers the opening. The first heat dissipation substrate 1213 and the second heat dissipation substrate 1214 are in contact with each other through the opening, and implement thermal conduction.

The separator 160 is included, so that the first cavity 1111 and the second cavity 1112 can be separated. Therefore, sealing of the first cavity 1111 is ensured, and the heat emitting element 220 inside the first cavity 1111 is protected to a maximum extent. This helps improve the overall protection level of the device 200 and prolong the service life of the device 200.

In addition, separating the first cavity 1111 from the second cavity 1112 through the separator 160 also facilitates arrangement of a power device, so that the device 200 is compact in internal structure and small in overall size. Therefore, control costs are controlled effectively.

To implement thermal conduction between the heat dissipation component 120 located in the first cavity 1111 and the heat dissipation component 120 located in the second cavity 1112, in this embodiment of this application, the heat dissipation apparatus 100 may further include a thermally conductive medium. The thermally conductive medium is disposed at the opening and located between the first heat dissipation substrate 1213 and the second heat dissipation substrate 1214. The first heat dissipation substrate 1213 and the second heat dissipation substrate 1214 implement thermal conduction by using the thermally conductive medium.

It should be added that, in the related technology, there is a small uneven gap between a surface of an electronic material and a heat sink. If the electronic material and the heat sink are directly installed together, an actual contact area between the electronic material and the heat sink is only 10% of an area of a base of the heat sink, and the rest is an air gap. As a result, a thermal contact resistance between the electronic material and the heat sink is high, which seriously hinders heat conduction, and reduces efficiency of the heat sink.

Therefore, a thermally conductive medium is usually disposed between the surface of the electronic material and the heat sink. The thermally conductive medium is a thermally conductive medium material synthesized from a base material such as silicone and various additional auxiliary materials such as metal oxides by using a special process. The gap is filled with the thermally conductive medium, to help extract air between the electronic material and the heat sink and establish a heat conduction channel between the electronic material and the heat sink. Therefore, the actual contact area can be greatly enlarged, the thermal contact resistance can be reduced, and the heat sink can act well. On the other hand, the thermally conductive medium has specific natural viscosity, so that connection performance is good, and both operability and maintainability are high.

It should be noted that, in this embodiment of this application, the thermally conductive medium may be thermally conductive silicone, thermally conductive silicone grease, thermally conductive filling adhesive, or thermally conductive gap filling adhesive.

In a possible implementation, referring to FIG. 9, the assembly slot 1215 is provided on a surface of the first heat dissipation substrate 1213. The assembly slot 1215 is opened toward the first cavity 1111. At least a part of the heat emitting element 220 is accommodated in the assembly slot 1215.

In this embodiment of this application, the first heat dissipation fin 1221 may be disposed on a part of the surface of the first heat dissipation substrate 1213 excluding the assembly slot 1215. In this way, on the one hand, the first heat dissipation fin 1221 located in the first cavity 1111 may be arranged in more diversified manners. On the other hand, in this disposing manner, a heat dissipation area of the first heat dissipation fin 1221 is larger, so that a heat dissipation area inside the first cavity 1111 can be enlarged to a maximum extent, and a heat dissipation capability of the first cavity 1111 is further improved.

In a possible implementation, referring to FIG. 7 and FIG. 8, the heat dissipation component 120, the first heat dissipation fan 130, and the air hood 150 that are located in the first cavity 1111 may be integrated.

In this way, on the one hand, assembly components and assembly steps between components such as the heat dissipation component 120 and the first heat dissipation fan 130 can be simplified, thereby helping ensure that a position relationship between the foregoing structures is constant. On the other hand, when heat dissipation needs to be performed on another device 200, the entire heat dissipation apparatus 100 may be moved more conveniently. In addition, flexible design adjustment and installation may be implemented based on a spatial position and the like inside the cavity 111, and operability is high.

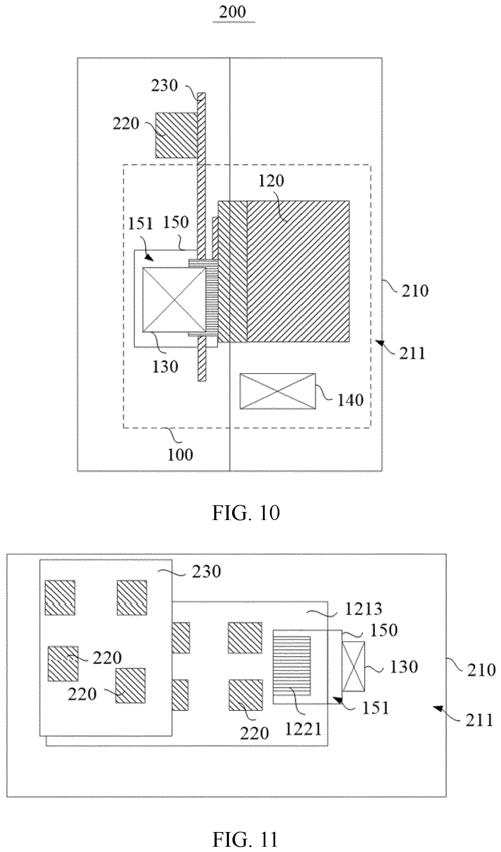

Referring to FIG. 10 and FIG. 11, an embodiment of this application further provides a device 200. The device 200 may include a box 210, a heat emitting element 220, and a heat dissipation apparatus 100. The device 200 in this embodiment of this application is an inverter.

The box 210 has an accommodating cavity 211. The heat dissipation apparatus 100 is accommodated in the accommodating cavity 211. The heat emitting element 220 is accommodated in a first cavity 1111 of the heat dissipation apparatus 100.

In a possible implementation, referring to FIG. 10, the device 200 further includes a circuit board 230. The circuit board 230 is disposed in the first cavity 1111. The circuit board 230 is included, and the circuit board 230 can supply power to the heat emitting element 220 and the heat dissipation component 120, thereby maintaining normal operation of the heat emitting element 220.

It should be noted that, in this embodiment of this application, a quantity of heat emitting elements 220, a size of the circuit board 230, and the like are not limited. For example, a position relationship between the heat emitting element 220 and the circuit board 230 may be set as shown in FIG. 10, or may be set as shown in FIG. 11.

The device 200 provided in this embodiment of this application includes the foregoing heat dissipation apparatus 100. Therefore, the device 200 has features and effects of the foregoing heat dissipation apparatus 100. The heat dissipation apparatus 100 includes the heat dissipation component 120, the first heat dissipation fan 130, and the second heat dissipation fan 140. The heat dissipation component 120 dissipates heat of the heat emitting element 220 to reduce a temperature of the heat emitting element 220, thereby ensuring that the temperature of the heat emitting element 220 remains within a preset range. The heat dissipation area inside the cavity 111 can be enlarged under the joint action of the heat dissipation component 120, the first heat dissipation fan 130, and the second heat dissipation fan 140. In addition, the hot air flow passes through the heat dissipation component 120 at a high speed, so that the convective heat exchange capability can be improved, which enhances the heat dissipation capability of the cavity 111 to a maximum extent, and further helps reduce heat dissipation costs of the heat emitting element 220.

In the description of this application, it should be noted that, unless otherwise specified or limited, terms such as "installation", "connected", and "connection" should be construed in a broad sense. For example, a "connection" may be a fixed connection, may be an indirect connection through an intermediate medium, or may be internal communication between two elements or an interaction relationship between two elements. Persons of ordinary skill in the art can understand specific meanings of these terms in this application based on specific situations.

The apparatus or element in this application or an implied apparatus or element needs to have a specific direction and be structured and operated in the specific direction, and therefore cannot be construed as a limitation on this application. In the description of this application, "a plurality of means two or more, unless otherwise precisely and specified.

In the specification, claims, and accompanying drawings of this application, terms "first", "second", "third", "fourth", and the like (if existing) are intended to distinguish between similar objects but do not necessarily indicate a specific order or sequence. It should be understood that data termed in such a way are interchangeable in proper circumstances, so that embodiments of this application described herein can be implemented in orders except the order illustrated or described herein. In addition, the terms "include" and "have" and any other variants are intended to cover the non-exclusive inclusion. For example, a process, method, system, product, or device that includes a list of steps or units is not necessarily limited to those expressly listed steps or units, but may include other steps or units not expressly listed or inherent to such a process, method, product, or device.

Finally, it should be noted that the foregoing embodiments are merely intended for describing the technical solutions of this application other than limiting this application. Although this application is described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions of embodiments of this application.

## Claims

1. A heat dissipation apparatus, configured to dissipate heat of a heat emitting element, wherein the heat dissipation apparatus comprises a housing, a heat dissipation component, a first heat dissipation fan, and a second heat dissipation fan;
the housing has a cavity, the cavity comprises a first cavity and a second cavity that are not communicated, the first cavity is a sealed cavity, the second cavity communicates with an external environment, and the first cavity is configured to accommodate the heat emitting element;
one part of the heat dissipation component is located in the first cavity, the other part of the heat dissipation component is located in the second cavity, the heat dissipation component located in the first cavity is in thermal conduction with the heat dissipation component located in the second cavity, and the heat dissipation component located in the first cavity is configured to dissipate the heat of the heat emitting element;
the first heat dissipation fan is disposed in the first cavity, and is configured to: transfer the heat of the heat emitting element to the heat dissipation component located in the first cavity, and transfer heat of a hot air flow to the heat dissipation component located in the second cavity; and
the second heat dissipation fan is disposed in the second cavity, and is configured to: suck a cold air flow from the external environment, perform heat exchange with the heat dissipation component located in the second cavity, and exhaust a hot air flow generated through the heat exchange to the external environment.

2. The heat dissipation apparatus according to claim 1, wherein the heat dissipation component comprises a heat dissipation substrate and a heat dissipation fin;
the heat dissipation substrate comprises, along a thickness direction of the heat dissipation substrate, a first surface and a second surface, the first surface is a surface, facing the first cavity, of the heat dissipation substrate, and the second surface is a surface, facing the second cavity, of the heat dissipation substrate; and
the heat dissipation fin is disposed on the heat dissipation substrate, and is in thermal conduction with the heat dissipation substrate.

3. The heat dissipation apparatus according to claim 2, wherein the heat dissipation substrate comprises a first heat dissipation substrate, and the heat dissipation fin comprises a first heat dissipation fin and a second heat dissipation fin; and
the first heat dissipation substrate is disposed in the first cavity or the second cavity, the first heat dissipation fin is disposed in the first cavity and located on a side on which a first surface of the first heat dissipation substrate is located, and the second heat dissipation fin is disposed in the second cavity and located on a side on which a second surface of the first heat dissipation substrate is located.

4. The heat dissipation apparatus according to claim 2, wherein the heat dissipation substrate comprises a first heat dissipation substrate and a second heat dissipation substrate, and the heat dissipation fin comprises a first heat dissipation fin and a second heat dissipation fin;
the first heat dissipation substrate and the first heat dissipation fin are disposed in the first cavity, and the first heat dissipation fin is located on a first surface of the first heat dissipation substrate; and
the second heat dissipation substrate and the second heat dissipation fin are disposed in the second cavity, and the second heat dissipation fin is located on a second surface of the second heat dissipation substrate.

5. The heat dissipation apparatus according to any one of claims 1 to 4, comprising an air hood, wherein the air hood is disposed in the first cavity, and an air duct is formed in the air hood; and
the air duct has a first air vent and a second air vent that communicate with each other, and the second air vent faces the first heat dissipation fan.

6. The heat dissipation apparatus according to claim 5, wherein the first heat dissipation fan is an air suction fan, the first air vent is an air inlet, and the second air vent is an air outlet; or
the first heat dissipation fan is an air exhaust fan, the first air vent is an air outlet, and the second air vent is an air inlet.

7. The heat dissipation apparatus according to claim 6, wherein a cold air flow inlet and a hot air flow outlet are disposed on the housing, and both the cold air flow inlet and the hot air flow outlet communicate with the second cavity;
the second heat dissipation fan is configured to: suck the cold air flow from the external environment through the cold air flow inlet, perform heat exchange with the heat dissipation component located in the second cavity, and exhaust, through the hot air flow outlet, the hot air flow generated through heat exchange to the external environment; and
the second cavity, the cold air flow inlet, the external environment, and the hot air flow outlet form a circulating cold and hot air flow exchange loop.

8. The heat dissipation apparatus according to claim 4, comprising a separator, wherein the separator is disposed in the cavity, and divides the cavity into the first cavity and the second cavity;
an opening is provided on the separator at a position close to the first heat dissipation substrate and the second heat dissipation substrate, and the opening communicates with the first cavity and the second cavity; and
a projection of at least one of the first heat dissipation substrate and the second heat dissipation substrate on the separator covers the opening, and the first heat dissipation substrate and the second heat dissipation substrate are in contact with each other through the opening, and implement thermal conduction.

9. The heat dissipation apparatus according to claim 8, further comprising a thermally conductive medium, wherein the thermally conductive medium is disposed at the opening and located between the first heat dissipation substrate and the second heat dissipation substrate; and
the first heat dissipation substrate and the second heat dissipation substrate implement thermal conduction by using the thermally conductive medium.

10. The heat dissipation apparatus according to claim 4, wherein an assembly slot is provided on a surface of the first heat dissipation substrate, the assembly slot is opened toward the first cavity, and at least a part of the heat emitting element is accommodated in the assembly slot; and
there are a plurality of heat emitting elements, there are a plurality of assembly slots, and the plurality of heat emitting elements are accommodated in the assembly slots in a one-to-one correspondence manner.

11. The heat dissipation apparatus according to claim 10, wherein the first heat dissipation fin is disposed on a part of the surface of the first heat dissipation substrate excluding the assembly slot.

12. The heat dissipation apparatus according to claim 5, wherein the heat dissipation component, the first heat dissipation fan, and the air hood that are located in the first cavity are integrated.

13. A device, comprising a box, a heat emitting element, and the heat dissipation apparatus according to any one of claims 1 to 12, wherein
the box has an accommodating cavity, the heat dissipation apparatus is accommodated in the accommodating cavity, and the heat emitting element is accommodated in the first cavity of the heat dissipation apparatus.
